# EUROPEAN PATENT APPLICATION

(11) **EP 0 997 929 A1**
(43) Date of publication of application: **03.05.2000**
(21) Application number: 98402724.3
(22) Date of filing: 30.10.1998
(51) Int. Cl.: H01L 21/311, H01L 21/312

(54) **Plasma etching of polymer materials**

(71) Applicant: Tokyo Electron Limited, Tokyo 107-8481 (JP); COMMISSARIAT A L'ENERGIE ATOMIQUE, 75752 Paris Cédex 15 (FR)
(72) Inventor: Vivensang, Christophe P., 38240 Le Versoud (FR); Vinet, Françoise, 38000 Grenoble (FR)
(74) Representative: Thévenet, Jean-Bruno

(57) **Abstract**

A mineral material layer and a photoresist polymer material layer are successively formed on a polymer material (6) supported by a substrate (5). The photoresist polymer material layer is patterned by way of lithography, and the pattern thus defined is transferred to the mineral material layer in order to form a hard mask (7a). The polymer material (6) is then dry etched using a plasma generated from a gas mixture comprising sulphur dioxide (SO₂), oxygen (O₂) and argon (Ar). The use of sulphur dioxide enables to carry out anisotropic etching in the polymer material (6). Further a good etching selectivity can be achieved thanks to the hard mask (7a).

## Description

The present invention generally pertains to a method for fabricating semiconductor devices. More particularly, the present invention concerns a method for etching a polymer, which polymer can typically be used as a dielectric insulating layer in a semiconductor device.

Semiconductor devices generally comprise a lower active area, called "front end", which consists, for example, of transistors, various p and/or n junctions, buried structures, etc., and an upper part, called "back end" which connects the different parts of the lower active area between each other.

Due to the small dimensions currently involved in semiconductor devices, cables cannot be used for interconnecting different parts of a lower active area. Instead, the back end of the semiconductor devices includes patterned metal layers separated with each other by insulating dielectric layers. Contact holes are formed in the insulating dielectric layers and filled with metal so as to enable connection of the various patterned metal layers with each other and with the lower active area of the device, thereby ensuring the appropriate electrical connections between the different parts of the lower active area.

Each patterned metal layer typically consists of one or several metal lines located in a same plane. These lines can be formed by etching a dielectric layer so as to form slots therethrough, and filling the slots with metal.

In order to form contact holes and/or slots in a given dielectric layer, the latter is etched according to a predetermined pattern. For this purpose, a dry etching technique can be used. Known dry etching techniques involve the use of a plasma etching chamber comprising, notably, two electrodes and a Radio-Frequency power supply, and containing a gas mixture. A wafer, comprising a dielectric layer to be etched, is introduced into the etching chamber. The RF power supply generates a glow discharge in the gas mixture between the two electrodes so as to produce a plasma. The plasma etches the dielectric layer by way of appropriate chemical reactions which take place between particular compounds of the plasma and the dielectric layer material. Generally, the plasma generation is accompanied by an ion bombardment which enhances the etching operation.

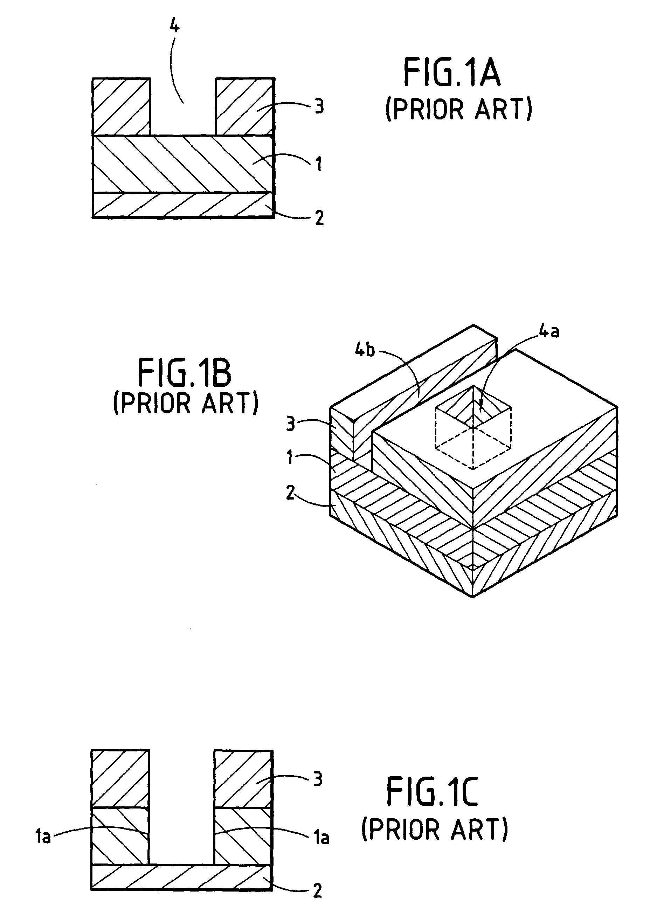

Figures 1A, 1B and 1C diagrammatically show a prior art method for etching a dielectric material layer using a plasma. The dielectric layer, designated by reference numeral 1, is supported by a substrate 2. A mask, or resist, 3 is formed on the dielectric layer 1. The mask 3 is patterned in such a manner that apertures 4, such as through-holes 4a and slots 4b, be defined therethrough, as shown in perspective view on figure 1B.

The wafer comprising layers 1, 2 and 3 is placed inside the etching chamber (not shown). The plasma generated in the chamber etches the dielectric layer 1 through the apertures 4, in order for the pattern defined in the mask 3 to be transferred to the dielectric layer 1 (see figure 1C). Then the mask 3 is removed from the wafer.

In the prior art, the dielectric layer 1 is composed of a mineral material, typically silicon oxide (SiO₂), whereas the mask 3 is composed of an organic material.

An important requirement in the etching process is that the plasma selectively etches the dielectric material, i.e., the plasma etches the dielectric layer 1 without eroding the mask 3 too much. Indeed, if the mask 3 is damaged during the etching process, the pattern defined therein will be modified and an accurate etching of the dielectric layer will not be possible.

Further, it is sometimes desired that the etching process be anisotropic. An etching process is anisotropic when the dielectric material is etched in a single direction, which is normal to the surface of the wafer. In such a case, the side walls 1a (figure 1C) resulting from the etching process remain substantially straight and are not etched in a lateral direction. Anisotropic etching is preferred over isotropic etching when a great accuracy is required in the manufacturing of the semiconductor device.

With the semiconductor devices being smaller and smaller, it is important to use, on the one hand, metallic materials whose conductivity is increased, and, on the other hand, dielectric materials whose dielectric constant is reduced.

It is currently envisaged to use polymer materials as dielectric in semiconductor devices. These materials indeed have a lower dielectric constant than mineral materials. However, the known methods for etching mineral materials cannot be used for polymer materials. A first reason therefor is that the conventional gas mixtures which serve to produce the plasma are not suitable for etching polymer materials. A second reason is that, even if a suitable gas mixture was used, the plasma would erode the mask too much as it is etching the polymer material.

There is then a need for a method which could efficiently, rapidly and anisotropically etch polymer materials.

There is also a need for a method which could selectively etch a polymer material, i.e., which could etch the polymer material without eroding the overlying mask too much.

The present invention aims to satisfy these needs.

For this purpose, there is provided a method for etching a polymer material, characterised in that it comprises the steps of forming a first mask comprising a mineral material on said polymer material, said first mask having a pattern etched therein; generating a plasma from a gas mixture comprising oxygen and sulphur-bearing gas such as sulphur dioxide; and etching said polymer material using said plasma so as to transfer said pattern to said polymer material.

The first mask, which comprises a mineral material, is not really affected by the action of the plasma. The polymer material can therefore be selectively etched. Thus, thanks to the combined use of a gas mixture comprising oxygen and sulphur-bearing gas such as sulphur dioxide and a mask comprising a mineral material, the present invention makes it possible to fabricate semiconductor devices with great accuracy.

The polymer material is etched by the chemical action of the plasma, which is accompanied by an ion bombardment directed towards the surface of the polymer material. More precisely, the oxygen atoms contained in the plasma chemically react with the polymer to form volatile species, thereby removing portions of the polymer material. The sulphur dioxide chemically reacts with the polymer to form non-volatile species, such as CₓS_{y} and more particularly CS₂, which protect the sidewalls of the apertures being formed in the polymer material from the etching process. Anisotropic etching can thus be carried out. The ion bombardment removes the non-volatile species deposited on the bottom of the apertures being formed, thus avoiding the risk of etch stop which could occur if a CS₂ layer was to remain on the polymer surface portions to be etched.

Preferably, the gas mixture further comprises a carrier gas, such as argon. The presence of a carrier gas indeed enables to appropriately mix the various compounds constituting the plasma.

The polymer material to be etched can further comprise a mineral compound, such as silicon. In such a case, the gas mixture further comprises at least one fluorine-based compound.

According to the present invention, the step of forming the first mask comprises the steps of: forming a first layer comprising a mineral material on the polymer material; forming a second mask comprising a polymer material on said first layer, said second mask having said pattern etched therein; and etching the first layer so as to transfer said pattern to the first layer. The step of etching the first layer typically uses a plasma etching technique.

According to the present invention, the step of forming the second mask comprises the steps of: forming a second layer comprising a polymer material on said first layer; and etching the second layer so as to produce said pattern. Typically, the step of etching the second layer uses a lithography technique.

Further, according to the present invention, the second mask is removed during the step of etching the polymer material. No particular additional treatment is then required to remove the second mask.

Further advantages of the present invention will be apparent from the reading of the following detailed description of preferred embodiments, made with reference to the accompanying drawings in which:
- figures 1A, 1B and 1C show a prior art etching method;
- figures 2A to 2F show an etching method according to the present invention;
- figure 3 shows the supply of a gas mixture into a plasma etching chamber;
- figure 4 shows an isotropically etched material; and
- figure 5 shows the deposition of CS₂ on an aperture being formed in a polymer material during the etching process, according to the present invention.

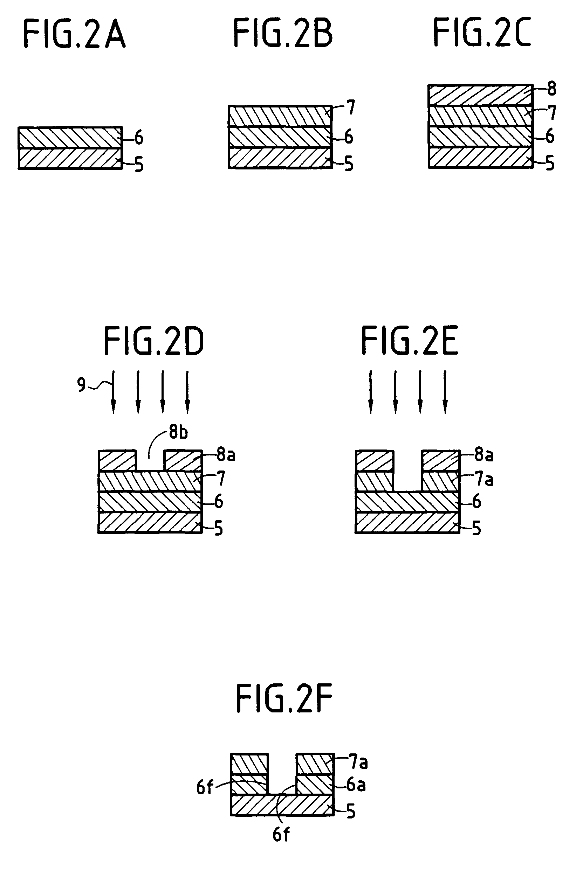

The plasma etching method according to the present invention is illustrated in figures 2A to 2F.

At a first step, a polymer material layer to be etched 6 is formed on a substrate 5 (figure 2A). By "substrate" we mean here an underlying layer, i.e., a layer which is formed before the polymer material layer 6 during the manufacturing of a semiconductor device. The polymer material which composes the layer 6 is, for example, the SiLK (Registered Trademark) material commercialised by the DOW CHEMICAL COMPANY.

At a second step, a mineral material layer 7 is formed on the polymer material layer 6 (figure 2B). The mineral material which composes the layer 7 is, for example, silicon oxide (SiO₂).

At a third step, a photoresist polymer material layer 8 is formed on the mineral material layer 7 (figure 2C).

The layers 6, 7 and 8 are formed using conventional techniques, such as the spin coating technique or the PECVD (Plasma Enhanced Chemical Vapour Deposition) technique.

At a fourth step, the photoresist polymer material layer 8 is patterned by lithography so as to form a mask 8a (figure 2D). The mask 8a comprises through-holes and/or slots 8b, which define the respective locations of the contact holes and/or slots to be formed in the polymer material layer 6.

At a fifth step, a dry etching method is applied to the wafer 5, 6, 7, 8a such that the pattern defined in the mask 8a be transferred to the mineral material layer 7 to form a mineral material mask 7a, called "hard mask" (figure 2E). Typically, the dry etching method used at the fifth step is a plasma etching method, of the type conventionally used for etching mineral material layers, such as SiO₂ layers, through polymer material masks. Such a method is described, for example, in US-A-5,595,627. It generally consists in placing the wafer in a plasma chamber and generating a plasma from a gas mixture comprising, notably, carbo-fluorinated compounds (CₓF_{y}). The carbo-fluorinated compounds chemically react with the silicon oxide composing the mineral material layer. The species obtained by such a chemical reaction are volatile, so that the mineral material layer is etched by removal of portions thereof. The plasma chamber is configured such that the plasma etching process be accompanied by an ion bombardment directed towards the wafer, as shown by arrows 9 on figure 2D. The plasma etching chamber used by the present invention is of the type described in US-A-5,717,294.

At a sixth step, the pattern defined in the mineral material mask 7a is transferred to the polymer material layer 6 according to the method described herebelow.

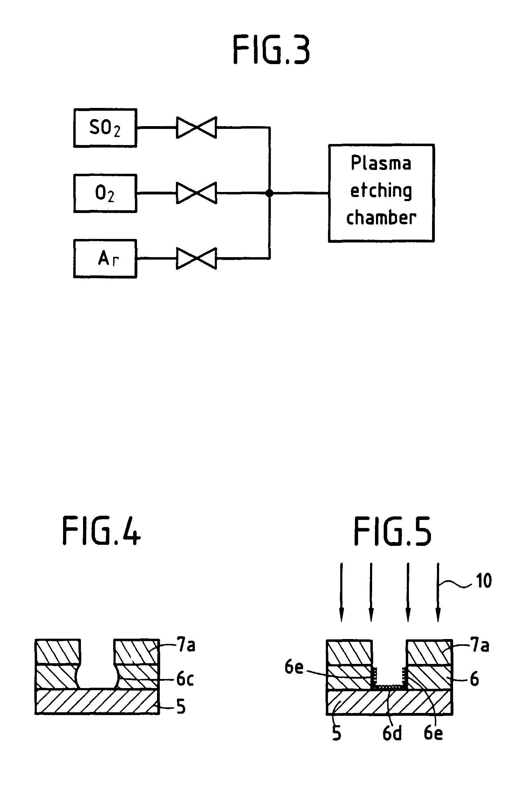

The gas mixture which was used for performing the fifth step is output from the plasma etching chamber. Another gas mixture, comprising sulphur dioxide (SO₂), oxygen (O₂) and argon (Ar), is then supplied into the plasma chamber, as shown on figure 3. A plasma is generated from the latter gas mixture while the wafer is disposed in the plasma chamber. The operation parameters of the plasma chamber are selected such that an ion bombardment be directed towards the wafer.

The oxygen atoms (O) resulting from the dissociation of the oxygen (O₂) and the sulphur dioxide (SO₂) in the plasma etches the polymer material by chemically reacting with the carbon of the polymer to form volatile (gaseous) species. However, a problem which may occur when using oxygen as an etching element is that the oxygen not only etches the polymer material in a direction normal to the surface thereof, but also in a direction parallel to such surface. The side walls 6c of the apertures (contact holes and/or slots) resulting from the etching process are then curved, as shown in figure 4.

The sulphur dioxide (SO₂) contained in the gas mixture makes it possible to avoid this problem. Indeed, during the etching process, the sulphur dioxide chemically reacts with the carbon of the polymer material to form a CS₂ layer on the bottom 6d and the side walls 6e of the apertures being formed, as diagrammatically shown on figure 5. The ion bombardment, illustrated at 10 on figure 5, which accompanies the chemical action of the plasma removes the CS₂ layer present on the aperture bottom 6d, while leaving the CS₂ layer formed on the side walls 6e unaffected. The CS₂ layer on the side walls 6e protects the latter from the action of the oxygen such that the side walls are not etched. Thus, thanks to the presence of sulphur dioxide in the gas mixture, an anisotropic etching can be carried out, resulting in the formation of contact holes and slots with straight side walls, as shown at 6f in figure 2F.

The argon contained in the gas mixture acts as a carrier gas which enables to mix the various species constituting the plasma, thereby obtaining a plasma being uniform on the whole surface of the wafer. Other carrier gases which could perform the same function as argon are known by the skilled person.

The present inventors have experimentally found that very satisfactory results, in terms of anisotropy and etching rapidity, are obtained when the operation parameters of the etching chamber are set substantially as follows for carrying out the above-described sixth step:
Flow rate of the SO₂ into the etching chamber: 20 sccm.
Flow rate of the O₂ into the etching chamber: 20 sccm.
Flow rate of the Ar into the etching chamber: 100 sccm.
Pressure inside the etching chamber: 20 mtorr (2.67 Pa).
RF power injected into the etching chamber: 800 W.
RF frequency: 13.56 MHz.
Wafer temperature: 20 °C.

The above method has been successfully carried out with a wafer, wherein, by way of example, the polymer material layer to be etched 6 has a thickness of typically 10,000 Å; the mineral material layer 7 formed on the polymer material layer 6 has a thickness of typically 1,500 Å, and the photoresist polymer material layer 8 formed on the mineral layer 7 has a thickness of typically 6,000 Å.

The method according to the invention may be applied to wafers having layers of different thicknesses. However, the photoresist polymer material layer 8 has preferably a thickness which is lower than or equal to that of the polymer material layer 6.

In the present invention, the overlying mask 8a is eroded as the polymer material layer 6 is being etched by the plasma, since the mask 8a and the layer 6 are both made of a polymer material. Therefore, if the mask 8a has a thickness which is lower than or equal to that of the polymer material layer 6, the mask 8a will be fully removed at the end of the sixth step. There is therefore no need to apply a particular treatment to the mask 8a in order to remove the latter.

As previously indicated, the polymer material layer 6 can be made of the SiLK (Registered Trademark) material. This material is essentially polymeric. In this particular case, where the polymer material does not contain any mineral compound such as silicon, best results are obtained when the etching of the polymer material is carried out in a fluorine-free process chamber. The mineral material layer 7 may thus be etched in a separate second chamber to avoid that the residual fluorine compounds which may rest on the walls of the first process chamber react with the plasma. As a matter of fact, when a single process chamber is used, due to the presence of fluorine in the plasma phase the selectivity of the etching towards the mineral material layer 7 may be reduced and the anisotropic character of the etching of the polymer material layer 6 may also be affected.

As a variant, however, the layer 6 can be composed of a polymer material which contains one or several mineral compounds. Such a material is, for example, the BCB (divinylsiloxane-bisbenzocyclobutene) material (Registered Trademark), which contains a small amount of silicon.

When the present invention uses the BCB material as the polymer material to be etched, the gas mixture entered into the etching chamber further comprises one or several fluorine-based compounds, such as for instance CF₄, C₂F₆ ,C₄F₈ or CF₄O₂. These compounds enable to etch the silicon contained in the polymer material.

There are provided herebelow optimum values for the operation parameters of the etching chamber during the sixth step, in the case where the BCB material is used for the layer 6 and the fluorine-based compound added to the gas mixture is C₄F₈:
Flow rate of the SO₂ into the etching chamber: 40 sccm.
Flow rate of the O₂ into the etching chamber: 90 sccm.
Flow rate of the C₄F₈ into the etching chamber: 10 sccm.
Flow rate of the Ar into the etching chamber: 100 sccm.
Pressure inside the etching chamber: 30 mtorr (4 Pa).
RF power injected into the etching chamber: 600 W.
RF frequency: 13.56 MHz.
Wafer temperature: 20 °C.

These values can of course be substantially modified for carrying out the sixth step of the etching method according to the present invention.

## Claims

1. Method for etching a polymer material (6), characterised in that it comprises the steps of:
forming a first mask (7a) comprising a mineral material on said polymer material (6), said first mask having a pattern etched therein;
generating a plasma from a gas mixture comprising oxygen and sulphur-bearing gas such as sulfur dioxide; and
etching said polymer material (6) using said plasma so as to transfer said pattern to said polymer material (6).

2. Method according to claim 1, characterised in that said mineral material comprises silicon oxide.

3. Method according to claim 1 or 2, characterised in that said gas mixture further comprises a carrier gas, such as argon.

4. Method according to any one of claims 1 to 3, characterised in that said polymer material (6) further comprises a mineral compound.

5. Method according to claim 4, characterised in that said mineral compound comprises silicon.

6. Method according to claim 4 or 5, characterised in that said gas mixture further comprises at least one fluorine-based compound.

7. Method according to any one of claims 1 to 6, characterised in that said step of forming said first mask (7a) comprises the steps of:
forming a first layer (7) comprising a mineral material on said polymer material (6);
forming a second mask (8a) comprising a polymer material on said first layer (7), said second mask having said pattern etched therein; and
etching said first layer (7) so as to transfer said pattern to said first layer.

8. Method according to claim 7, characterised in that said step of etching said first layer uses a plasma etching technique.

9. Method according to claim 7 or 8, characterised in that said step of forming said second mask (8a) comprises the steps of:
forming a second layer (8) comprising a polymer material on said first layer (7); and
etching said second layer (8) so as to produce said pattern.

10. Method according to claim 9, characterised in that said step of etching said second layer (8) uses a lithography technique.

11. Method according to any one of claims 7 to 10, characterised in that said second mask (8a) is removed during the step of etching said polymer material (6).
